# EUROPÄISCHE PATENTSCHRIFT

(11) **EP 0 920 579 B1**
(45) Veröffentlichungstag und Bekanntmachung des Hinweises auf die Patenterteilung: **10.11.2004**
(21) Anmeldenummer: 98933470.1
(22) Anmeldetag: 09.05.1998
(51) Int. Cl.: F02D 41/22, F02D 41/18, G01D 3/08

(54) **VORRICHTUNG ZUR ERKENNUNG EINES FEHLERHAFTEN SIGNALES**
DEVICE FOR THE RECOGNITION OF A DEFECTIVE SIGNAL
DISPOSITIF POUR LA RECONNAISSANCE D'UN SIGNAL DEFECTUEUX

(30) Priorität: 26.06.1997 DE 19727204
(43) Veröffentlichungstag der Anmeldung: 09.06.1999
(73) Patentinhaber: ROBERT BOSCH GMBH, 70442 Stuttgart (DE)
(72) Erfinder: WILD, Ernst, D-71739 Oberriexingen (DE); PFITZ, Manfred, D-71665 Vaihingen (DE)
(86) Internationale Anmeldenummer: PCT/DE1998/001270
(87) Internationale Veröffentlichungsnummer: WO 1999/000593

(56) Entgegenhaltungen:
- DE-A- 4 204 623
- GB-A- 2 285 145
- GB-A- 2 300 484
- US-A- 4 199 799
- US-A- 5 095 743

## Beschreibung

Die Erfindung geht aus von einer Vorrichtung zur Erkennung eines fehlerhaften Signales nach der Gattung des Hauptanspruchs.

### Stand der Technik

Bei der Erfassung einer wesentlichen Meßgröße kann es erforderlich sein, daß zur Erfassung zwei voneinander unabhängig arbeitende Sensorsysteme eingesetzt werden. Bei solchen redundanten Systemen läßt sich dann anhand eines Vergleichs der von den Sensorsystemen gelieferten Signale ein Fehler erkennen, wenn beispielsweise ein Signal einen oberen Grenzwert überschreitet oder einen unteren Grenzwert unterschreitet.

Es ist jedoch weiterhin auch möglich, beide Signale miteinander zu vergleichen und beispielsweise den Abstand zwischen zwei Signalen zu überwachen um einen Fehler zu erkennen, wenn die Differenz der beiden Signale einen vorgebbaren Grenzwert überschreitet. Eine solche Plausibilitätsuntersuchung wird beispielsweise in der DE-OS 43 44 633 sowie in der DE 195 16 583 durchgeführt.

Bei dieser bekannten Plausibilitätsuntersuchung werden im Zusammenhang mit der Lasterfassung bei einer Brennkraftmaschine das sogenannte Hauptlastsignal und das sogenannte Nebenlastsignal miteinander verglichen. Das Hauptlastsignal wird dabei bestimmt, indem mit Hilfe eines Luftmassenmessers die von der Brennkraftmaschine angesaugte Luftmasse direkt ermittelt wird. Die Erfassung des Hauptlastsignals kann auch indirekt mit einem Saugrohrdrucksensor erfolgen. Dabei wird unter Berücksichtigung der Ansauglufttemperatur, des Restgasanteils und des Zylinderhubvolumens unter Verwenduung der Gasgleichung die angesaugte Frischluftmasse errechnet. Das Nebenlastsignal wird bei beiden Verfahren (Drucksensor bzw. Luftmassenmesser) durch Auswertung der Drehzahl und der Winkellage der Drosselklappe der Brennkraftmaschine, beispielsweise mit Hilfe eines Drosselklappenpotentiometers gebildet. Sowohl das Hauptlastsignal als auch das Nebenlastsignal müssen bei ordnungsgemäßer Funktionsweise des Luftmassenmessers oder des Drucksensors bzw. des Drosselklappenpotentiometers und optimaler Anpassung einander weitgehend entsprechen. Treten dennoch Abweichungen auf, kann auf einen Fehler eines der beiden Sensorsysteme geschlossen werden.

### Vorteile der Erfindung

Die erfindungsgemäße Vorrichtung zur Erkennung eines fehlerhaften Signales kann in vorteilhafter Weise sicher und zuverlässig erkennen, wenn einer von zwei die gleiche Meßgröße ermittelnden Sensoren ein fehlerhaftes Ausgangssignal liefert. Dabei ist besonders vorteilhaft, daß ein fehlerhaftes Signal auch dann noch erkannt wird, wenn es innerhalb eines an sich gültigen Bereiches liegt. Es kann damit erkannt werden, wenn einer der beiden Sensoren ein konstantes Signal abgibt, das noch plausibel ist, obwohl sich die zu messende Größe ändert, das heißt fehlende Dynamik auf dem defekten Signalpfad wird erkannt.

Erzielt werden diese Vorteile, indem die beiden Signale nicht direkt miteinander verglichen werden, sondern zunächst gefiltert werden und jeweils der Betrag des gefilterten Signales gebildet wird. Durch Differenzbildung der Beträge der gefilterten Signale lassen sich besonders zuverlässige Bedingungen erzeugen, die zur Fehlererkennung herangezogen werden. So kann insbesonders in vorteilhafter Weise ein Fehler erkannt werden, indem das Vorzeichen der Differenz der beiden Signale zur Fehlererkennung ausgewertet wird. Die Fehlererkennung bzw. die Plausibilitätsüberwachung basiert somit in vorteilhafter Weise auf der Varianz der beiden Signale. Diese Überwachung hat gegenüber der aus der DE-OS 43 44 633 bekannten Überwachung, die auf einem Vergleich von Signalpegeln basiert, den Vorteil, daß sie zuverlässiger ist und auch bei kleineren Fehlfunktionen eines Sensors zuverlässig arbeitet.

Weitere Vorteile der Erfindung werden durch die in den Unteransprüchen angegebenen Maßnahmen erzielt. Ein besonderer Vorteil besteht darin, daß auch erkannt wird, welches der beiden Signale fehlerhaft ist. Erzielt wird dieser Vorteil, indem nach der Differenzbildung eine spezielle Plausibilitätsuntersuchung unter Verwendung logischer Mittel abläuft.

Anstelle einer Differenzbildung des Betrags der gefilterten Signale kann auch eine Quotientenbildung vorgesehen werden. Der Vergleich des Quotienten mit wenigstens einem Schwellwert läßt ebenfalls einen Fehler erkennen.

### Zeichnung

Ein Ausführungsbeispiel der Erfindung ist in der einzigen Figur dargestellt und wird in der nachfolgenden Beschreibung näher erläutert.

### Beschreibung des Ausführungsbeispiels

Die Erfindung wird anhand eines Ausführungsbeispieles erläutert, das der Lasterfassung einer Brennkraftmaschine entspricht. Grundsätzlich ist die Erfindung jedoch nicht auf die Lasterfassung bei einer Brennkraftmaschine eingeschränkt, sondern kann auf alle physikalische Größen ausgedehnt werden, wobei Voraussetzung ist, daß die betreffende physikalische Größe mittels zweier verschiedener Sensoren erfaßt wird.

Für die Regelung einer Brennkraftmaschine ist die Last eine sehr wesentliche Größe. Unter Last wird dabei beispielsweise die angesaugte Luftmasse verstanden. Die Bestimmung der angesaugten Luftmasse erfolgt üblicherweise auf zwei verschiedene Arten. Zum einen ist im Saugrohr der Brennkraftmaschine ein Luftmassenmesser oder Saugrohrdrucksensor angeordnet. Luftmassenmesser werten das Prinzip aus, daß die strömende Luft eine beheizte Fläche abkühlt. Die Funktionsweise von Heißfilmluftmassenmessern ist bekannt und wird an dieser Stelle nicht näher erläutert. Das Ausgangssignal, das vom Luftmassenmesser erzeugt wird, wird als sogenanntes Hauptlastsignal bezeichnet und dient dem Steuergerät der Brennkraftmaschine als wesentliche Regelgröße.

Da das Lastsignal eine derart wesentliche Größe ist, wird es noch nach einer zweiten Methode bestimmt. Das nach der zweiten Methode bestimmte Lastsignal wird üblicherweise als Nebenlastsignal bezeichnet, es wird üblicherweise in Abhängigkeit vom gemessenen Drosselklappenwinkel, der Drehzahl der Brennkraftmaschine und gegebenenfalls weiterer Größe ermittelt. Bei einer optimalen Anpassung der beiden Lasterfassungen muß das Nebenlastsignal und das Hauptlastsignal bei ordnungsgemäßer Funktion beider Sensoren nahezu identisch sein. Ist dies nicht der Fall, muß wenigstens eines der beiden Signale fehlerhaft sein. Die zuverlässige Fehlererkennung wird wie folgt durchgeführt:

Das vom Luftmassenmesser bzw. Drucksensor gelieferte Signal S1, das das Hauptlastsignäl oder Füllungshauptsignal ist, wird zunächst einem Differenzierer 10 zugeführt. Der Differenzierer mit Verzögerer 10 umfaßt im wesentlichen einen Tiefpaß 11 und einen Subtrahierer 12. Das Signal S1 wird dabei einmal direkt zum Subtrahierer 12 und einmal über den Tiefpaß 11 geleitet. Im Subtrahierer 12 wird das tiefpaßgefilterte Signal vom Signal S1 abgezogen. Als Tiefpaß 11 wird vorteilhafterweise ein Tiefpaß verwendet, dessen Eigenschaften veränderbar sind. Dazu wird beispielsweise die Filterkonstante 13 verändert.

Das differenzierte Signal S11 wird einem Betragsbildner 14 zugeführt. Durch die Betragsbildung wird der dynamische Anteil des differenzierten Füllungshauptsignales S11 gleichgerichtet. In einem nachfolgenden Filter, beispielsweise einem Tiefpaß 15 wird das pulsierende Gleichspannungssignal geglättet. Als Filterausgangssignal steht damit eine Gleichspannung MW1 zur Verfügung, die proportional zur Eingangssignaldynamik ist.

Das Füllungsnebensignal bzw. Nebenlastsignal S2 wird in gleicher Weise weiterverarbeitet wie das Füllungshauptsignal. Es wird also zunächst einem Differenzierer mit Verzögerer 16 zugeführt, der ebenfalls einen Tiefpaß und einen Subtrahierer umfaßt. Das differenzierte Signal S22 wird im Betragsbildner 17 gleichgerichtet und im Tiefpaß 18 geglättet. Am Ausgang des Tiefpasses 18 entsteht so eine Gleichspannung MW2, die proportional zur Eingangssignaldynamik des Signals S2 ist.

Die beiden so aufbereiteten Signale bzw. die Spannungen MW1 und MW2 werden einem Subtrahierer 19 zugeführt, der die Differenzspannung D zwischen den beiden Spannungen bildet. Die Signaldifferenzspannung D wird im wesentlichen zur Fehlererkennung ausgewertet.

Sind beide Signale S1 und S2 vorhanden und liegt Signaldynamik vor, stellt sich am Ausgang des Subtrahierers 19 eine Differenzspannung von D = 0 V ein. Bei einem Defekt am Füllungsersatzsignal S2, also z. B. einem Defekt am Drosselklappenpotentiometer wird die Spannung des Tiefpaßfilters 18 auf 0 V abklingen. Am Tiefpaß 15 des Füllungshauptsignales wird dagegen bei einer Signaldynamik weiterhin eine positive Spannung anstehen. Wird die Ausgangsspannung D des Subtrahierers 19 in einem Vergleichsmittel 20, beispielsweise einem Komparator mit einem Schwellwert verglichen, läßt sich ein Fehler erkennen, wenn die Spannung den Schwellwert SW1 überschreitet. Bei Überschreiten des Schwellwertes SW1 wird dann durch Setzen eines Flip-Flops 21 auf defektes Füllungsersatzsignal erkannt und eine Fehlermeldung 22 abgegeben.

Tritt ein Defekt im Füllungshauptsignal auf, beispielsweise wenn der Luftmassenmesser bzw. Drucksensor nicht oder nicht richtig arbeitet oder bei einer Signalpfadunterbrechung stellt sich am Ausgang des Subtrahierers 19 eine negative Ausgangsspannung ein. Durch Vergleich der Spannung D mit einem negativen Schwellwert -SW1 läßt sich wiederum ein Fehler dann erkennen, wenn die Spannung D den Schwellwert - SW1 unterschreitet. Der Vergleich findet im Block 23 statt, durch anschließendes Setzen eines Flip-Flops 24 läßt sich eine Fehlerbedingung 25 aktivieren, die anzeigt, daß im Füllungshauptsignalzweig ein Fehler vorhanden sein muß.

Mit Hilfe des Und-Gatters 26, das über die beiden Vergleichseinrichtungen 27 und 28 mit den Ausgängen der beiden Tiefpässe 15 und 18 verbunden ist, läßt sich eine Fehlerverriegelung über die beiden Flip-Flops 21 und 24 aufbauen. Eine solche Fehlerverriegelung ist notwendig, da sonst ein erkannter Füllungssignalfehler bei nachlassender Dynamik des noch intakten Signalzweiges als wieder geheilt erkannt würde. Eine Heilung kann jedoch nur bei hoher Signaldynamik nach Überschreiten einer Heilschwelle beider Signale erfolgen. Dazu wird in den Vergleichseinrichtungen 27 und 28 die Spannung MW1 daraufhin überwacht, ob sie einen Schwellwert SW2 übersteigt. In der Vergleichseinrichtung 28 wird die Spannung MW2 ebenfalls daraufhin überwacht, ob sie den Schwellwert SW2 übersteigt. Nur wenn beide Spannungen höher sind als der Schwellwert SW2 schaltet das Und-Gatter 26 um, so daß an die beiden R-Eingänge der Flip-Flops 21 und 24 ein entsprechendes Signal gelangt.

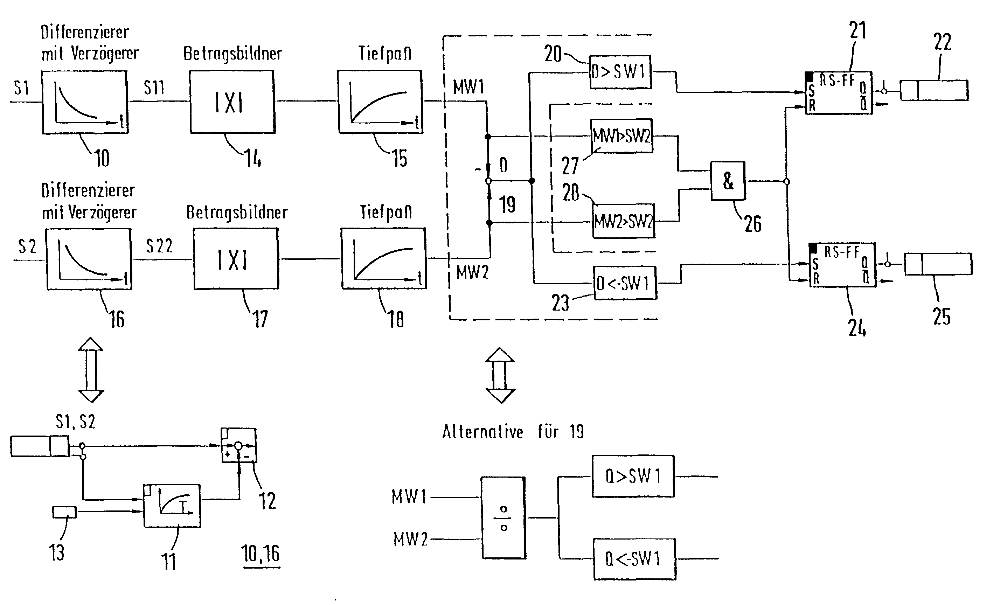

Der Aufbau der Anordnung nach Figur 1 läßt sich mit diskreten Bauteilen aufbauen, kann aber auch softwaremäßig in einer Recheneinrichtung, beispielsweise im Steuergerät der Brennkraftmaschine realisiert sein. Die Schwellwerte SW1 und SW2 sind den Erfordernissen entsprechend auszuwählen. Grundsätzlich beruht die erfindungsgemäße Plausibilitätsüberwachung auf der Auswertung der Varianz der beiden Signale.

Anstelle der Differenzbildung im Subtrahierer 19 könnte auch eine Quotientenbildung der Spannungen MW1 und MW2 durchgeführt werden. Da der Quotient je nach auftretendem Fehler entweder positiv oder negativ wird, könnte nach der Quotientenbildung 29 ein Vergleich 30 oder 31 ablaufen, bei dem der Quotient Q daraufhin überwacht wird, ob er größer ist als ein Schwellwert SW1 oder kleiner als ein Schwellwert SW1. Bei Überschreiten des Schwellwertes SW1 würde ein Fehler des Hauptlastsignales und bei Unterschreiten des Schwellwertes -SW1 ein Fehler des Nebenlastsignales erkannt werden.

## Patentansprüche

1. Vorrichtung zur Erkennung eines fehlerhaften Signales mit ersten und zweiten Signalerzeugungsmitteln, die die gleiche Meßgröße erfassen und ein erstes und ein zweites Signal (S1, S2) liefern, wobei Mittel (10, 14, 15, 16, 17,18) zur Aufbereitung des ersten und zweiten Signals vorgesehen sind, wobei ein Fehler durch einen Vergleich der aufbereiteten Signale (MW1, MW2) erkannt wird, **dadurch gekennzeichnet, dass** die aufbereiteten Signale proportional zur Eingangssignaldynamik der jeweiligen Signale (S1, S2) ist.

2. Vorrichtung zur Erkennung eines fehlerhaften Signales nach Anspruch 1, **dadurch gekennzeichnet, daß** die beiden Signale (S1) und (S2) jeweils einem Differenzierer mit Verzögerer (10, 16) zugeführt werden, daß die Ausgangssignale der beiden Differenzierer mit Verzögerer einem Betragsbildner (14, 17) zugeführt werden, daß die Ausgangssignale der Betragsbildner (14, 17) je einem Filter (15, 18) zugeführt werden und daß die Ausgangssignale (MW1), (MW2) der Filter (15, 18) in einem Differenzierer (19) miteinander verglichen werden zur Erzeugung einer Differenz (D), die in Vergleichsmitteln (20, 23) mit Schwellwertes (SW1, -SW1) verglichen werden, wobei ein Fehler erkannt wird, wenn die Differenz (D) größer als (SW1) oder kleiner als (-SW1) ist.

3. Vorrichtung zur Erkennung eines fehlerhaften Signales, **dadurch gekennzeichnet, daß** der Differenzierer mit Verzögerer (10) und/oder (16) wenigstens einen Tiefpaß (11) und einen Differenzbildner (12) umfaßt, daß das Signal (S1) und/oder (S2) direkt dem Differenzbildner (12) und dem Tiefpaß (11) zugeführt wird und der Ausgang des Tiefpasses (11) im Differenzbildner (12) vom Signal (S1) abgezogen wird.

4. Vorrichtung zur Erkennung eines fehlerhaften Signales nach einem der vorhergehenden Ansprüche, **dadurch gekennzeichnet, daß** die Vergleichsmittel (20, 23) jeweils mit einem Flip-Flop (21, 24) in Verbindung stehen und weitere Vergleichsmittel (27, 28), in denen die Ausgangsspannungen der Filter (15, 18) mit einem Schwellwert (SW2) verglichen werden mit einem Und-Gatter (26) verbunden sind, dessen Ausgang auf die beiden R-Eingänge der Flip-Flops (21, 24) führen.

5. Vorrichtung zur Erkennung eines fehlerhaften Signales nach Anspruch 4, **dadurch gekennzeichnet, daß** die Vergleichsmittel (20, 23, 27 und 28), das Und-Gatter (26) und die Flip-Flops (21, 24) eine Fehlerverriegelung bilden, die eine Fehlerheilung nur dann erlauben, wenn bei hoher Signaldynamik eine Heilschwelle von beiden Signalen überschritten wird.

6. Vorrichtung zur Erkennung eines fehlerhaften Signales nach einem der vorhergehenden Ansprüche, **dadurch gekennzeichnet, daß** das erste Signal (S1) das Füllungsnebensignal einer Brennkraftmaschine und das Signal S2 das Füllungshauptsignal ist, wobei das Füllungsnebensignal in Abhängigkeit von der Drosselklappenstellung und der Drehzahl der Brennkraftmaschine gebildet wird und das Füllungshauptlastsignal von einem Luftmassenmesser geliefert wird.

7. Vorrichtung zur Erkennung eines fehlerhaften Signales, nach einem der vorhergehenden Ansprüche, **dadurch gekennzeichnet, daß** aus dem Vorzeichen des Ausgangssignales des Differenzbildners (19) erkannt wird, welches Signal fehlerhaft ist.

8. Vorrichtung zur Erkennung eines fehlerhaften Signales nach einem der vorhergehenden Ansprüche, **dadurch gekennzeichnet, daß** der Differenzbildner (19) ersetzt wird durch einen Quotientenbildner und daß der Quotient (Q) bzw. das Vorzeichen des Quotienten (Q) zur Fehlererkennung ausgewertet wird.

## Claims

1. Apparatus for identifying an erroneous signal with first and second signal generation means which detect the same measured variable and supply a first and a second signal (S1, S2), where means (10, 14, 15, 16, 17, 18) for conditioning the first and second signals are provided, with an error being identified by virtue of a comparison of the conditioned signals (MW1, MW2), **characterized in that** the conditioned signals are proportional to the input signal dynamics of the respective signals (S1, S2).

2. Apparatus for identifying an erroneous signal according to Claim 1, **characterized in that** the two signals (S1) and (S2) are supplied to a respective differentiator with delay elements (10, 16), **in that** the output signals from the two differentiators with delay elements are supplied to an absolute-value formation unit (14, 17), **in that** the output signals from the absolute-value formation units (14, 17) are supplied to a respective filter (15, 18), and **in that** the output signals (MW1), (MW2) from the filters (15, 18) are compared with one another in a differentiator (19) in order to produce a difference (D) which is compared with threshold values (SW1,-SW1) in comparison means (20, 23), with an error being identified if the difference (D) is greater than (SW1) or less than (-SW1).

3. Apparatus for identifying an erroneous signal, **characterized in that** the differentiator with delay elements (10) and/or (16) comprises at least one low-pass filter (11) and a difference formation unit (12), **in that** the signal (S1) and/or (S2) is supplied directly to the difference formation unit (12) and to the low-pass filter (11), and the output of the low-pass filter (11) in the difference formation unit (12) is deducted from the signal (S1).

4. Apparatus for identifying an erroneous signal according to one of the preceding claims, **characterized in that** the comparison means (20, 23) are connected to a respective flip-flop (21, 24), and further comparison means (27, 28), in which the output voltages from the filters (15, 18) are compared with a threshold value (SW2), are connected to an AND gate (26) whose output is routed to the two R-inputs of the flip-flops (21, 24).

5. Apparatus for identifying an erroneous signal according to Claim 4, **characterized in that** the comparison means (20, 23, 27 and 28), the AND gate (26) and the flip-flops (21, 24) form an error latch which permits errors to be remedied only if, given high signal dynamics, a remedial threshold is exceeded by both signals.

6. Apparatus for identifying an erroneous signal according to one of the preceding claims, **characterized in that** the first signal (S1) is the ancillary filling signal for an internal combustion engine and the signal (S2) is the primary filling signal, with the ancillary filling signal being formed on the basis of the throttle-valve position and the speed of the internal combustion engine, and the primary filling load signal being supplied by an air-mass flowmeter.

7. Apparatus for identifying an erroneous signal according to one of the preceding claims, **characterized in that** the arithmetic sign of the output signal from the difference formation unit (19) is used to identify which signal is erroneous.

8. Apparatus for identifying an erroneous signal according to one of the preceding claims, **characterized in that** the difference formation unit (19) is replaced by a quotient formation unit, and **in that** the quotient (Q) or the arithmetic sign of the quotient (Q) is evaluated for the purpose of error identification.

## Revendications

1. Dispositif pour la reconnaissance d'un signal défectueux comportant des premiers et des seconds moyens de production de signaux qui saisissent la même grandeur à mesurer et délivrent un premier et un second signal (S1, S2), des moyens (10, 14, 15, 16, 17, 18) étant prévus pour traiter le premier et le second signal, de sorte qu'un défaut est reconnu en comparant les signaux traités (MW1, MW2),
**caractérisé en ce que**
les signaux traités sont proportionnels à la dynamique du signal d'entrée du signal correspondant (S1, S2).

2. Dispositif pour la reconnaissance d'un signal défectueux selon la revendication 1,
**caractérisé en ce que**
les deux signaux (S1, S2) sont envoyés chacun à un différentiateur équipé d'un temporisateur (10, 16), les signaux de sortie des deux différentiateurs équipés de temporisateurs sont envoyés à un afficheur de valeur (14, 17), les deux signaux de sortie de ces afficheurs sont adressés chacun à un filtre (15, 18) dont les signaux de sortie (MW1, MW2) sont comparés entre eux dans un différentiateur (19) pour donner une différence (D) qui, dans des moyens de comparaison (20, 23) est comparée à une valeur de seuil (SW1), et un défaut est reconnu quand la différence (D) est supérieure à (SW1) ou inférieure à (-SW1).

3. Dispositif pour la reconnaissance d'un signal défectueux,
**caractérisé en ce que**
le différentiateur équipé d'un temporisateur (10) et/ou (16) comprend au moins un passe-bas (11) et un afficheur de différence (12), le signal et/ou est envoyé directement à l'afficheur de différence (12) et (S1) et/ou (S2) au passe-bas (11) et la sortie du passe-bas (11) est soustraite du signal (S1) dans l'afficheur de différence (12).

4. Dispositif pour la reconnaissance d'un signal défectueux selon une des revendications précédentes,
**caractérisé en ce que**
les moyens de comparaison (20, 23) sont en liaison avec une bascule bi-stable (21, 24) respectivement, et d'autres moyens de comparaison (27, 28) dans lesquels les tensions de sortie des filtres (15, 18) sont comparées à une valeur de seuil (SW2), sont reliés à une porte ET (26) dont la sortie conduit aux deux entrées R des bascules bi-stables (21, 24).

5. Dispositif pour la reconnaissance d'un signal défectueux selon la revendication 4,
**caractérisé en ce que**
les moyens de comparaison (20, 23, 27 et 28), la porte ET (26) et les bascules bi-stables (21, 24) constituent un blocage sur erreur qui autorise seulement le traitement de l'erreur quand, dans le cas d'une dynamique de signal élevée, un seuil de traitement est dépassé par les deux signaux.

6. Dispositif pour la reconnaissance d'un signal défectueux selon une des revendications précédentes,
**caractérisé en ce que**
le premier signal (S1) est le signal secondaire de remplissage d'un moteur à combustion interne, tandis que le signal (S2) est le signal principal de remplissage, le signal secondaire (S1) étant établi en fonction de la position du clapet d'étranglement et de la vitesse du moteur, tandis que le signal principal de remplissage (S2) est délivré par un appareil de mesure de la masse d'air.

7. Dispositif pour la reconnaissance d'un signal défectueux selon une des revendications précédentes,
**caractérisé en ce qu'**
on reconnaît quel signal est défectueux par le signe du signal de sortie de l'afficheur de différence (19).

8. Dispositif pour la reconnaissance d'un signal défectueux selon une des revendications précédentes,
**caractérisé en ce que**
l'afficheur de différence (19) est remplacé par un afficheur de quotient, le quotient (Q) et le signe de ce quotient étant traités pour reconnaître l'erreur.
